# EUROPÄISCHE PATENTSCHRIFT

(11) **EP 3 652 615 B1**
(45) Veröffentlichungstag und Bekanntmachung des Hinweises auf die Patenterteilung: **08.12.2021**
(21) Anmeldenummer: 18743429.5
(22) Anmeldetag: 10.07.2018
(51) Int. Cl.: G06F 3/01, G06F 3/041, B60K 37/06

(54) **BEDIENEINHEIT FÜR EIN GERÄT**
OPERATOR CONTROL UNIT FOR A DEVICE
UNITÉ DE COMMANDE POUR UN APPAREIL

(30) Priorität: 12.07.2017 DE 102017115673
(43) Veröffentlichungstag der Anmeldung: 20.05.2020
(73) Patentinhaber: Behr-Hella Thermocontrol GmbH, 59557 Lippstadt (DE)
(72) Erfinder: TRAPP, Ralph, 33106 Paderborn (DE)
(74) Vertreter: dompatent von Kreisler Selting Werner - Partnerschaft von Patent- und Rechtsanwälten mbB
(86) Internationale Anmeldenummer: PCT/EP2018/068640
(87) Internationale Veröffentlichungsnummer: WO 2019/011906

(56) Entgegenhaltungen:
- EP-A1- 3 167 946
- US-A1- 2002 171 637
- US-A1- 2003 076 297
- US-A1- 2013 009 892
- US-A1- 2014 218 324
- US-A1- 2016 103 493
- US-A1- 2016 195 932
- US-A1- 2017 052 593
- US-A1- 2017 148 587

## Beschreibung

Die Erfindung betrifft eine Bedieneinheit für ein Gerät, insbesondere für ein Fahrzeug zur Bedienung einer Fahrzeugkomponente und insbesondere MMI bzw. HMI. Insbesondere betrifft die Erfindung eine Bedieneinheit mit haptischem Feedback.

Bedieneinheiten mit berührungsempfindlichen Bedienoberflächen wie beispielsweise Touchscreens oder Touchpads zeichnen sich durch eine hohe Variabilität der Bedienoberfläche und durch einen großen Bedienkomfort aus. Um dem Bediener eine valide Bedienung der Bedieneinheit rückzumelden, verfügen derartige Bedieneinheiten über eine Feedback-Funktion, die entweder optisch, akustisch oder taktil arbeitet. Insbesondere taktile haptische Feedback-Funktionen erfreuen sich zunehmender Beliebtheit, und zwar zumeist gepaart mit einer Force-Sense-Eigenschaft, bei der über einen beispielsweise Kraft- oder Wegsensor eine Minimalauslenkung der Bedienoberfläche detektiert werden kann, was der Detektierung einer validen Bedienung der Bedienoberfläche dient (siehe hierzu z. B. WO-A-2016/135425 und WO-A-2016/012277).

Bedieneinheiten mit haptischem Feedback sind vielfach als schwingungsfähige Systeme ausgebildet, indem die Bedienoberfläche bzw. das Bedienelement mit der berührungsempfindlichen Bedienoberfläche elastisch gelagert ist und für das haptische Feedback mechanisch angeregt wird. Die mechanische Anregung erfolgt über einen Aktuator, beispielsweise in Form eines Zuganker-Elektromagnets, der dann ebenfalls Teil des schwingungsfähigen Systems ist.

Das elastisch aufgehängte schwingungsfähige System neigt dazu, bei Fremdanregung wie beispielsweise insbesondere während der Fahrt durch auf das Fahrzeug einwirkenden Vibrationen in Schwingung versetzt zu werden. Dies kann zu störenden Geräuschen führen, was nachteilig sein kann.

Aufgabe der Erfindung ist es, eine Bedieneinheit mit haptischem Feedback dahingehend zu verbessern, dass Schwingungen infolge von ungewollten Fremdanregungen des elastisch aufgehängten schwingungsfähigen Systems weitestgehend unterdrückt werden.

Zur Lösung dieser Aufgabe wird mit der Erfindung eine Bedieneinheit für ein Gerät, insbesondere für ein Fahrzeug zur Bedienung einer Fahrzeugkomponente und insbesondere MMI bzw. HMI, vorgeschlagen, die versehen ist mit
- einem Gehäuse,
- einem Bedienelement, das eine berührungsempfindliche Bedienoberfläche und eine Berührungssensorik aufweist,
- wobei das Bedienelement zur automatischen Rückführung nach einer Auslenkung aus seiner Ruhelage zurück in diese in und/oder an dem Gehäuse elastisch gelagert ist,
- einem Aktuator zur mechanischen Anregung des Bedienelements aus dessen Ruhelage zwecks taktiler Rückmeldung einer Betätigung des Bedienelements,
- einem Sensor zur Erkennung einer Bewegung des Bedienelements und/oder einer auf das Bedienelement wirkenden Beschleunigung und/oder Kraft und
- einer Auswerte- und Ansteuereinheit, die Signale von dem Sensor und der Berührungssensorik des Bedienelements empfängt und den Aktuator zur mechanischen Anregung des Bedienelements zwecks taktiler Rückmeldung einer Betätigung des Bedienelements ansteuert,
- wobei die Auswerte- und Ansteuereinheit bei Erkennung einer Bewegung des Bedienelements und/oder einer auf das Bedienelement wirkenden Beschleunigung und/oder Kraft, ohne dass in diesen Fällen eine Berührung der Bedienoberfläche sensiert wird, den Aktuator zur Beibehaltung der Ruhelage des Bedienelements und/oder zur Zurückbewegung des Bedienelements in dessen Ruhelage und/oder zur Stabilisierung des Bedienelements ansteuert.

Die erfindungsgemäße Bedieneinheit ist mit einem Gehäuse versehen, in bzw. an dem ein Bedienelement angeordnet ist, welches eine berührungsempfindliche Bedienoberfläche mit Berührungssensorik aufweist. Das Bedienelement ist in und/oder an dem Gehäuse elastisch gelagert, um nach einer Auslenkung aus seiner Ruhelage automatisch wieder in die Ruhelage zurückgeführt zu werden. Zwecks haptischem Feedback wird das Bedienelement durch mechanische Anregung mittels eines Aktuators aus der Ruhelage bewegt, wenn das Bedienelement betätigt worden ist bzw. wenn eine valide Bewegung des Bedienelements bei gleichzeitiger Detektion der Berührung der Bedienoberfläche detektiert wird.

Erfindungsgemäß weist die Bedieneinheit einen Sensor auf, der eine Bewegung des Bedienelements und/oder eine auf das Bedienelement wirkende Beschleunigung und/oder Kraft erkennt, ohne dass die Bedienoberfläche berührt worden ist (Detektion einer Fremdanregung des Bedienelements). Dieser Sensor liefert seine Messsignale an eine Auswerte- und Ansteuereinheit, die überdies Signale von der Berührungssensorik des Bedienelements empfängt. Die Auswerte- und Ansteuereinheit steuert bei Detektion einer validen Betätigung des Bedienelements den Aktuator zur mechanischen Anregung des Bedienelements zwecks taktiler haptischer Rückmeldung an. Diese Ansteuerung kann in Abhängigkeit von dem von der Berührungssensorik gelieferten Signal erfolgen (valide Betätigung bzw. mechanische Anregung des Bedienelements nur bei Detektion einer Berührung der Bedienoberfläche).

Erfindungsgemäß wird nun diese Auswerte- und Ansteuereinheit oder aber eine separat dazu ausgeführte Einheit genutzt, um eine Bewegung des Bedienelements und/oder eine auf das Bedienelement wirkende Beschleunigung und/oder eine auf das Bedienelement wirkende Kraft ohne gleichzeitige Sensierung einer Berührung der Bedienoberfläche zu nutzen, um den Aktuator zur Beibehaltung der Ruhelage des Bedienelements und/oder zur Zurückbewegung des Bedienelements in dessen Ruhelage anzusteuern. Wenn also beispielsweise das schwingungsfähige System der Bedieneinheit aufgrund auf die Bedieneinheit wirkenden Vibrationen ungewollt fremdangeregt wird, so arbeitet der Aktuator erfindungsgemäß sogleich gegen diese fremdangeregten Bewegungen des schwingungsfähigen Systems, hält also das Bedienelement in seiner Ruhelage bzw. überführt es bereits bei kleinsten Auslenkungen wieder in seine Ruhelage. Dadurch kann sich das schwingungsfähige System nicht "aufschaukeln", was damit die Entwicklung ungewollter Vibrationsgeräusche verhindert.

Der erfindungsgemäß vorgesehene Sensor zur Erkennung einer Bewegung des Bedienelements durch Fremdanregung kann ein Bauelement sein, das zusätzlich zu einem Kraft-Sensor vorgesehen ist. Der Kraft-Sensor dient der Detektion einer Krafteinleitung in das Bedienelement bei Berührung der Bedienoberfläche. Wenn also dieser Kraft-Sensor und die Berührungssensorik ansprechen, so ist dies ein Indiz dafür, dass das Bedienelement betätigt worden ist.

Die beiden zuvor beschriebenen Sensoren können nach gleichen Wirkprinzipien, also beide resistiv, kapazitiv, induktiv oder optisch arbeiten oder aber sie arbeiten nach unterschiedlichen Wirkprinzipien.

In vorteilhafter Weiterbildung der Erfindung kann vorgesehen sein, dass das Bedienelement ein Touchscreen oder ein Touchpad ist.

Ferner kann mit Vorteil vorgesehen sein, dass der Sensor außerhalb des Bedienelements und außerhalb von mit dem Bedienelement gekoppelten beweglichen Elementen angeordnet ist oder aber an dem Bedienelement angeordnet oder sich mit diesem mit bewegend mit dem Bedienelement gekoppelt ist.

In zweckmäßiger weiterer Fortbildung der Erfindung kann vorgesehen sein, dass der Aktuator als ein Elektromagnet mit einem Stator und einem relativ zu diesem bewegbaren Anker zur mechanischen Anregung des Bedienelements ausgebildet ist und dass der Sensor als Spule ausgebildet ist, die eine Bewegung des Ankers in Form einer induzierten Spulenspannung sensiert. Bei der als Sensor eingesetzten Spule kann es sich beispielsweise um die Erregerspule des Elektromagneten oder um eine separate Messspule beispielsweise am Anker oder am Stator des Elektromagneten handeln.

In weiterer vorteilhafter Ausgestaltung der Erfindung kann vorgesehen sein, dass der Aktuator zur mechanischen Anregung des Bedienelements mindestens ein piezokeramisches Element aufweist und dass das piezokeramische Element bei einer frei von einer Ansteuerung des Aktuators erfolgenden Bewegung des Bedienelements als Sensor arbeitet und diese Bewegung als sich in Folge des piezoelektrischen Effekts einstellende Spannung an dem piezokeramischen Element sensiert.

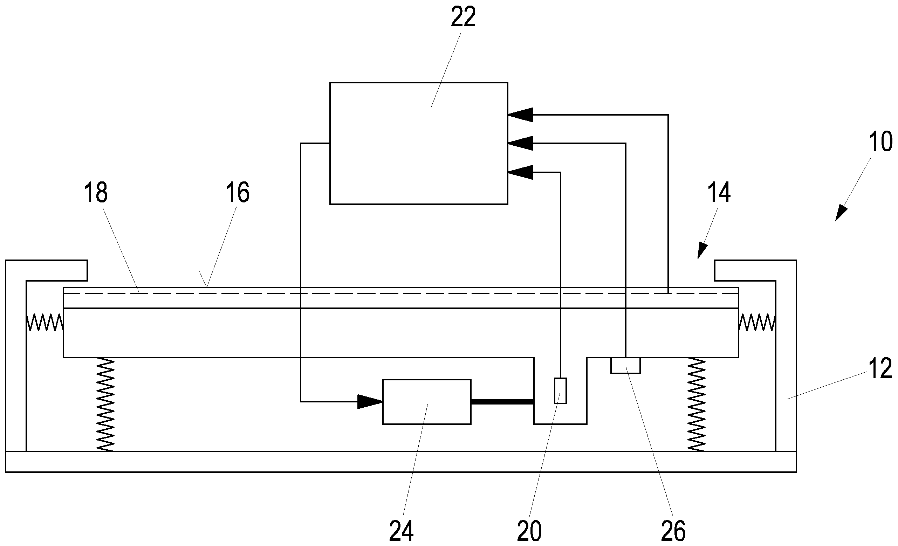

Die Erfindung wird nachfolgend anhand eines Ausführungsbeispiels und unter Bezugnahme auf die Zeichnung näher erläutert. In der Zeichnung ist schematisch eine Bedieneinheit mit einem Bedienelement mit taktilem haptischen Feedback und Force-Sense gezeigt.

Touchbedienelemente, wie Displays oder Touchpads, werden mittlerweile oft mit einer haptischen Rückmeldung versehen, um dem Benutzer eine zusätzliche Rückmeldung über das Auslösen einer Funktion oder das Auffinden einer aktiven Touchoberfläche zu geben. Gerade in der Automobilindustrie, wo Fahrerablenkungen so gering wie möglich gehalten werden sollen, kommen solche Systeme teilweise in Kombination mit einer Auslösekrafterkennung zum Einsatz. Die haptische Rückmeldung wird dabei meist durch eine Vibration der Touchoberfläche realisiert. Hierzu muss die Touchoberfläche beweglich zum Rest des Geräts gelagert sein. Aktive Elemente wie Elektromagnete oder Piezobausteine mit einer entsprechenden elektrischen Ansteuerung lenken dabei die Touchoberfläche in die gewünschte Richtung aus. Rückstellfedern bringen die Oberfläche in die Ausgangsposition zurück. Oft wird diese Bewegung durch passive Dämpferelemente gedämpft. Das Gesamtsystem ist somit schwingfähig. Abhängig von der Geometrie und Masse haben solche Systeme Resonanzfrequenzen. Wird das System in der Nähe dieser Frequenzen z.B. durch die Fahrzeugbewegung oder Vibrationen fremdangeregt, kann es zur Aufschaukelung der Bewegungen und zum ungewollten Schwingen der Touchoberfläche kommen. Damit ist dann auch oft eine ungewollte Geräuschentwicklung verbunden.

Gegenstand dieser Erfindung ist ein Mechanismus, der den oben geschilderten Effekt minimiert bzw. abstellt. Um auf eine Fremdanregung des Gesamtsystems reagieren zu können, muss diese detektiert werden. Dies kann entweder durch einen zusätzlichen Sensor in Form eines Beschleunigungs- bzw. Bewegungssensors oder aber durch das Antriebselement, das zur gewollten Bewegung der Oberfläche im Falle einer Rückmeldung dient, selbst erfolgen. Im letzteren Fall müsste bei der Verwendung eines Elektromagneten z.B. nach Tauchspulenprinzip die Spulenspannung gemessen werden. Hierbei würde sich durch die Relativbewegung von Magnet und Spule eine Fremdanregung durch die induzierte Spulenspannung detektieren lassen. Ist nun die Auslenkung der Touchoberfläche nach Betrag und Phase bekannt, kann über eine geeignete (z.B. gegenphasige) Ansteuerung des Aktuators, der zur gewollten Auslenkung der Oberfläche dient, die Fremdanregung gedämpft oder kompensiert werden. Der zusätzliche Beschleunigungs- bzw. Bewegungssensor kann sowohl in den feststehenden Teil des Gesamtsystems oder in den beweglichen Teil integriert werden. Im letzteren Fall ist eine Ansteuerung erforderlich, die über die Kenntnis der Dynamik des Systems die Phasenlage des beweglichen Teils errechnet und dementsprechend den Aktuator ansteuert.

Bezugnehmend auf das Ausführungsbeispiel gemäß der Zeichnung weist die Bedieneinheit 10 ein Gehäuse 12 auf, an bzw. in dem ein Bedienelement 14 mit einer Bedienoberfläche 16 und einer bei 18 angedeuteten Berührungssensorik angeordnet ist. In diesem Ausführungsbeispiel ist das Bedienelement 14 beispielsweise als Touchscreen ausgeführt.

Wie schematisch in der Zeichnung angedeutet, kann das Bedienelement 14 sowohl lateral als auch vertikal elastisch gelagert sein. Wird auf die Bedienoberfläche 16 des Bedienelements 14 eine Betätigungskraft ausgeübt, so lenkt sich das Bedienelement 14 geringfügig aus, was durch einen Betätigungssensor 20 erkannt wird. Die Berührung wird durch die Berührungssensorik 18 sensiert. Wenn beide Signale am Eingang einer Auswerte- und Ansteuereinheit 22 anliegen (und gegebenenfalls der Betätigungssensor 20 eine ausreichend große mechanische Einwirkung auf das Bedienelement 14 sensiert), so steuert die Auswerte- und Ansteuereinheit 22 einen Aktuator 24 an, der seinerseits mit dem Bedienelement 14 mechanisch gekoppelt ist und dieses in eine Schwingung versetzt bzw. auf dieses zumindest einen Bewegungsimpuls ausübt. Dies dient der taktilen haptischen Rückmeldung an den Benutzer, dass er das Bedienelement 14 in der für die Ausführung der gewünschten Funktion vorgeschriebenen Weise betätigt hat.

Das elastisch aufgehängte Bedienelement 14 gerät nun unbeabsichtigterweise aber auch dann in mechanische Schwingungen, wenn es durch von außen auf die Bedieneinheit 10 einwirkende Kräfte fremdangeregt wird. Hier ist beispielsweise während einer Fahrt auf ein Fahrzeug wirkende Erschütterungen die Ursache für eine derartige Fremdanregung.

Um nun das Bedienelement 14 infolge einer derartigen Fremdanregung nicht in Bewegung kommen zu lassen, dient erfindungsgemäß ein weiterer Sensor 26, der in denjenigen Richtungen sensitiv ist, in denen das Bedienelement 14 bei Fremdanregung in Schwingungen versetzt werden kann. In der Auswerte- und Ansteuereinheit 22 wird nun das Signal des Sensors 26 ausgewertet, um phasengenau den Aktuator 24 anzusteuern, damit dieser gegenphasig zur Fremdanregung des Bedienelements 14 dieses anregt, so dass im Idealfall das Bedienelement 14 seine Ruhelage beibehält. Sofern der Sensor 26 auch eine valide Betätigung des Bedienelements 14 sensiert bzw. sofern der Sensor 26 mit dem Betätigungssensor 20 oder umgekehrt vereinigt ist, bedarf es zur Detektion einer Fremdanregung zusätzlich noch der Auswertung der Berührungssensorik 18. Bei einer Fremdanregung sollte die Berührungssensorik 18 keine Berührung der Bedienoberfläche 16 des Bedienelements 14 sensieren.

### BEZUGSZEICHENLISTE

- 10: Bedieneinheit
- 12: Gehäuse
- 14: Bedienelement
- 16: Bedienoberfläche
- 18: Berührungssensorik
- 20: Betätigungssensor
- 22: Ansteuereinheit
- 24: Aktuator
- 26: Sensor

## Patentansprüche

1. Bedieneinheit für ein Gerät, insbesondere für ein Fahrzeug zur Bedienung einer Fahrzeugkomponente und insbesondere MMI bzw. HMI, mit
- einem Gehäuse (12),
- einem Bedienelement (14), das eine berührungsempfindliche Bedienoberfläche (16) und eine Berührungssensorik (18) aufweist,
- wobei das Bedienelement (14) zur automatischen Rückführung nach einer Auslenkung aus seiner Ruhelage zurück in diese in und/oder an dem Gehäuse (12) elastisch gelagert ist,
- einem Aktuator (24) zur mechanischen Anregung des Bedienelements (14) aus dessen Ruhelage zwecks taktiler Rückmeldung einer Betätigung des Bedienelements (14),
- einem Sensor (26) zur Erkennung einer Bewegung des Bedienelements (14) und/oder einer auf das Bedienelement (14) wirkenden Beschleunigung und/oder Kraft und
- einer Auswerte- und Ansteuereinheit (22), die Signale von dem Sensor (26) und der Berührungssensorik (18) des Bedienelements (14) empfängt und den Aktuator (24) zur mechanischen Anregung des Bedienelements (14) zwecks taktiler Rückmeldung einer Betätigung des Bedienelements (14) ansteuert,
**dadurch gekennzeichnet,**
- **dass** die Auswerte- und Ansteuereinheit (22) bei Erkennung einer Bewegung des Bedienelements (14) und/oder einer auf das Bedienelement (14) wirkenden Beschleunigung und/oder Kraft ohne Sensierung einer Berührung der Bedienoberfläche (16) den Aktuator (24) zur Beibehaltung der Ruhelage des Bedienelements (14) und/oder zur Zurückbewegung des Bedienelements (14) in dessen Ruhelage und/oder zur Stabilisierung des Bedienelements (14) ansteuert.

2. Bedieneinheit nach Anspruch 1, **dadurch gekennzeichnet, dass** das Bedienelement (14) ein Touchscreen oder ein Touchpad ist.

3. Bedieneinheit nach Anspruch 1 oder 2, **dadurch gekennzeichnet, dass** der Sensor (26) außerhalb des Bedienelements (14) und außerhalb von mit dem Bedienelement (14) gekoppelten beweglichen Elementen angeordnet ist.

4. Bedieneinheit nach Anspruch 1 oder 2, **dadurch gekennzeichnet, dass** der Sensor (26) an dem Bedienelement (14) angeordnet oder sich mit diesem mitbewegend mit dem Bedienelement (14) gekoppelt ist.

5. Bedieneinheit nach Anspruch 1 oder 2, **dadurch gekennzeichnet, dass** der Aktuator (24) als ein Elektromagnet mit einem Stator und einem relativ zu diesem bewegbaren Anker zur mechanischen Anregung des Bedienelements (14) ausgebildet ist und dass der Sensor (26) als Spule ausgebildet ist, die eine Bewegung des Ankers in Form einer induzierten Spulenspannung sensiert.

6. Bedieneinheit nach Anspruch 1 oder 2, **dadurch gekennzeichnet, dass** der Aktuator (24) zur mechanischen Anregung des Bedienelements (14) mindestens ein piezokeramisches Element aufweist und dass das piezokeramische Element bei einer frei von einer Ansteuerung des Aktuators (24) erfolgenden Bewegung des Bedienelements (14) als Sensor (26) arbeitet und diese Bewegung als sich in Folge des piezoelektrischen Effekts einstellende Spannung an dem piezokeramischen Element sensiert.

## Claims

1. An operating unit for a device, in particular for a vehicle for operating a vehicle component and in particular MMI or HMI, comprising
- a housing (12),
- an operating unit (14) comprising a touch-sensitive operating surface (16) and a touch sensor system (18),
- wherein the operating element (14) is elastically mounted to the housing (12) for the purpose of being automatically returned back to its rest position after being deflected out of said rest position,
- an actuator (24) for mechanical excitation of the operating element (14) out of its rest position for the purpose of tactile feedback in response to an operation of the operating element (14),
- a sensor (26) for detecting a movement of the operating element (14) and/or an acceleration and/or force acting on the operating element (14), and
- an evaluation and control unit (22) receiving signals from the sensor (26) of the touch sensor system (18) of the operating element (14) and controlling the actuator (24) for mechanical excitation of the operating element (14) for the purpose of tactile feedback in response to an operation of the operating element (14),
**characterized in that**
- when a movement of the operating element (14) and/or an acceleration and/or force acting on the operating element (14) are/is detected without sensing a touch on the operating surface (16), the evaluation and control unit (22) controls the actuator (24) to maintain the rest position of the operating element (14) and/or to move the operating element (14) back to its rest position and/or to stabilize the operating element (14).

2. The operating unit according to claim 1, **characterized in that** the operating element (14) is a touchscreen or a touchpad.

3. The operating unit according to claim 1 or 2, **characterized in that** the sensor (26) is arranged outside of the operating element (14) and outside of the movable elements coupled to the operating element (14).

4. The operating unit according to claim 1 or 2, **characterized in that** the sensor (26) is arranged at the operating element (14) or is coupled to the operating element (14) so as to move together with the operating element (14).

5. The operating unit according to claim 1 or 2, **characterized in that** the actuator (24) is configured as an electromagnet having a stator and an anchor movable relative to the stator for mechanical excitation of the operating element (14), and that the sensor (26) is configured as a coil sensing a movement of the anchor in the form of an induced coil voltage.

6. The operating unit according to claim 1 or 2, **characterized in that** the actuator (24) comprises at least one piezoceramic element for mechanical excitation of the operating element (14), and that the piezoceramic element works as a sensor (26), in case of a movement of the operating element (14) free from a control of the actuator (24), and senses said movement as a voltage at the piezoceramic element occurring as a result of the piezoelectric effect.

## Revendications

1. Unité de commande pour un appareil, en particulier pour un véhicule afin de commander un composant de véhicule et en particulier une IHM, dotée
- d'un boîtier (12),
- d'un élément de commande (14), lequel comporte une surface de commande (16) sensible au toucher et un système de capteurs de contact (18),
- dans laquelle l'élément de commande (14) est disposé de manière élastique dans et/ou sur le boîtier (12) pour le retour automatique à sa position de repos après avoir été déplacé hors de celle-ci,
- d'un actionneur (24) destiné à exciter mécaniquement l'élément de commande (14) hors de sa position de repos à des fins de rétroaction tactile d'un actionnement de l'élément de commande (14),
- d'un capteur (26) destiné à reconnaître un déplacement de l'élément de commande (14) et/ou une accélération et/ou une force s'exerçant sur l'élément de commande (14) et
- d'une unité de contrôle et de pilotage (22), laquelle reçoit des signaux du capteur (26) et du système de capteurs de contact (18) et pilote l'actionneur (24) destiné à exciter mécaniquement l'élément de commande (14) à des fins de rétroaction tactile d'un actionnement de l'élément de commande (14),
**caractérisée en ce que**
- l'unité de contrôle et de pilotage (22), en cas de reconnaissance d'un déplacement de l'élément de commande (14) et/ou d'une accélération et/ou d'une force s'exerçant sur l'élément de commande (14) sans détection d'un toucher de la surface de commande (16), commande l'actionneur (24) afin de maintenir la position de repos de l'élément de commande (14) et/ou afin de ramener l'élément de commande (14) dans sa position de repos et/ou afin de stabiliser l'élément de commande (14).

2. Unité de commande selon la revendication 1, **caractérisée en ce que** l'élément de commande (14) est un écran tactile ou un clavier tactile.

3. Unité de commande selon la revendication 1 ou 2, **caractérisée en ce que** le capteur (26) est disposé à l'extérieur de l'élément de commande (14) et à l'extérieur d'éléments mobiles couplés à l'élément de commande (14).

4. Unité de commande selon la revendication 1 ou 2, **caractérisée en ce que** le capteur (26) est disposé sur l'élément de commande (14) ou est couplé à l'élément de commande (14) afin de se déplacer avec celui-ci.

5. Unité de commande selon la revendication 1 ou 2, **caractérisée en ce que** l'actionneur (24) est réalisé comme un électroaimant doté d'un stator et d'une armature mobile par rapport à celui-ci destiné à exciter mécaniquement l'élément de commande (14) et **en ce que** le capteur (26) est réalisé comme bobine, laquelle détecte un mouvement de l'armature sous la forme d'une tension induite à ses bornes.

6. Unité de commande selon la revendication 1 ou 2, **caractérisée en ce que** l'actionneur (24) comporte au moins un élément piézocéramique destiné à exciter mécaniquement l'élément de commande (14) et **en ce que** l'élément piézocéramique fonctionne comme capteur (26) lors d'un déplacement de l'élément de commande (14) ne résultant pas d'un pilotage de l'actionneur (24) et détecte ce mouvement en tant que tension aux bornes de l'élément piézocéramique créée par l'effet piézoélectrique.
